# EUROPÄISCHE PATENTSCHRIFT

(11) **EP 2 387 798 B1**
(45) Veröffentlichungstag und Bekanntmachung des Hinweises auf die Patenterteilung: **05.09.2012**
(21) Anmeldenummer: 09774845.3
(22) Anmeldetag: 15.12.2009
(51) Int. Cl.: H01L 23/544, H01L 23/58, H04L 9/32

(54) **VERFAHREN ZUR VERIFIKATION EINER KENNZEICHNUNGSSCHALTUNG**
METHOD FOR VERIFYING AN IDENTIFICATION CIRCUIT
PROCÉDÉ DE VÉRIFICATION D'UN CIRCUIT D'IDENTIFICATION

(30) Priorität: 14.01.2009 DE 102009005255
(43) Veröffentlichungstag der Anmeldung: 23.11.2011
(73) Patentinhaber: KHS GmbH, 44143 Dortmund (DE)
(72) Erfinder: KEIL, Gernot, 55595 Braunweiler (DE)
(86) Internationale Anmeldenummer: PCT/EP2009/008956
(87) Internationale Veröffentlichungsnummer: WO 2010/081517

(56) Entgegenhaltungen:
- WO-A1-2007/056620
- DE-A1- 19 843 424
- US-A1- 2003 204 743
- US-A1- 2005 033 705

## Beschreibung

### Technisches Gebiet

Die vorliegende Erfindung betrifft ein Verfahren zur Verifikation von Kennzeichnungsschaltungen, insbesondere zur Verifikation der Originalität eines mit einer Kennzeichnungsschaltung gekennzeichneten Bauteils.

### Beschreibung des Standes der Technik

Hersteller von hochwertigen Produkten sehen sich zunehmend mit Fälschungen ihrer Produkte konfrontiert. Es werden nicht nur günstige und einfach herstellbare Einzelteile kopiert und in minderer Qualität als Fälschung auf den Markt gebracht. Vielmehr werden mittlerweile auch komplexe Bauteile und Baugruppen sowie komplette Vorrichtungen und Anlagen nachgebaut und im freien Handel angeboten.

Dies geschieht in zunehmend höherer Qualität und Präzision, so dass die Fälschungen teilweise nur noch schwer von den entsprechenden Originalteilen des Original-Herstellers unterscheidbar sind. War bisher meist eine flüchtige visuelle Prüfung zur Identifikation von Fälschungen ausreichend, so haben zwischenzeitlich selbst Fachleute große Schwierigkeiten die Nachbauten zu erkennen, so dass erst eine aufwendige Prüfung in einem Labor eine diesbezügliche Identifikation erlaubt. Auch die Vertriebswege der Fälschungen erreichen zunehmend professionelle Standards, so dass auch hieraus u. U. keine Rückschlüsse gezogen werden können. Die mangelnde Unterscheidbarkeit führt dazu, dass weder die Kunden beim Kauf der Produkte noch die Hersteller selbst, bspw. in einem Garantiefall, mit Sicherheit bestimmen können, ob es sich bei dem fraglichen Teil um ein Originalprodukt oder eine Fälschung handelt.

Verschiedene Kennzeichnungsvarianten sind zur Kennzeichnung von Produkten bekannt, wie bspw. Barcodes oder andere Sicherheits-Etiketten. Diese weisen jedoch den Nachteil auf, dass sie in der Regel einfach mit begrenztem Aufwand reproduzierbar sind.

Als schwer bzw. nicht reproduzierbare Strukturen gelten dagegen bspw. logische dreidimensionale Schaltungen, wie sie aus der Druckschrift DE 10 2005 033 218 A1 bekannt sind. Diese beschreibt eine dreidimensionale Schaltung mit wenigstens zwei übereinander liegenden Substratlagen, die Leiterbahnen und/oder Schaltungselemente umfassen, wobei die Substratlagen flexibel ausgebildet sind und die Leiterbahnen und/oder Schaltungselemente aus elektrischen Funktionsmaterialien bestehen.

Jedoch ist aus dem Stand der Technik nicht bekannt, derartige Schaltungen zur Verifikation der Originalität eines mit einer Schaltung gekennzeichneten Bauteils einzusetzen.

Aus US 2005/0033705 ist ein Verfahren gemäß dem Oberbegriff des Anspruchs 1 bekannt.

Es ist somit ein Ziel, ein Verfahren zur Verifikation der Originalität des mit der Schaltung gekennzeichneten Bauteils bereitzustellen.

### Zusammenfassung der Erfindung

Diese Aufgabe wird durch ein erfindungsgemäßes Verfahren nach Anspruch 1 gelöst.

Einige Ausführungsformen werden in den Unteransprüchen definiert.

Die in Anspruch 1 beschriebene Kennzeichnungsschaltung kann, wie voranstehend beschrieben, eine elektronische Schaltungsanordnung umfassen, die durch nichtleitende, halbleitende und leitende Materialien gebildet und nachfolgend lediglich als Schaltung bezeichnet wird. Die Materialien sind derart angeordnet, dass Schaltelemente, wie bspw. Transistoren, Kondensatoren, Spulen, Dioden, Widerstände und/oder Speicherelemente aufgebaut und miteinander kommunikationstechnisch verbunden werden. Die jeweilige Anordnung der einzelnen Schaltelemente der Schaltung zueinander gibt eine definierte Verarbeitung der in die Schaltung eingeleiteten Signale vor. Die mit der Anordnung definierte Verarbeitung repräsentiert eine definierte mathematische Funktion, gemäß der ein Eingabesignal abgeändert und ein entsprechendes Ausgabesignal erzeugt wird. Auf diese Weise ist es möglich, mittels der Anordnung eine mathematische Funktion in der Schaltung zu hinterlegen. Die Schaltung kann sowohl lediglich in einer Ebene als auch in mehreren Schichten als dreidimensionale Schaltung aufgebaut sein.

Wird also ein erster Eingabeschlüssel, bspw. der voranstehend genannte Primärschlüssel, in die Kennzeichnungsschaltung eingegeben, so wird der Eingabeschlüssel gemäß der in der Schaltung hinterlegten Funktion verändert und als abgeänderter Ausgabeschlüssel, wie bspw. der voranstehend genannte Sekundärschlüssel, ausgegeben. Die hinterlegte mathematische Funktion kann hierbei beliebig bei der Herstellung der Kennzeichnungsschaltung festgelegt werden. Die Schlüssel selbst bestehen bspw. aus Datensätzen bzw. Kennungen, die Signale oder Signalfolgen umfassen, wie sie in der Datenkommunikation bekannt sind.

Eine geeignete Kennzeichnung des jeweiligen Bauteils kann dadurch gewährleistet werden, dass die Kennzeichnungsschaltung direkt an dem Bauteil angeordnet ist. Zwar kann die Kennzeichnungsschaltung grundsätzlich auch auf einem Etikett bereitgestellt und auf das Bauteil geklebt sein, jedoch gewährleistet dies im Allgemeinen nicht, dass es sich bei dem Bauteil tatsächlich um ein Originalteil handelt. Lediglich die Originalität der Kennzeichnungsschaltung könnte in diesem Fall gewährleistet sein. Um jedoch die Originalität des Bauteils selbst auch garantieren zu können, ist es bspw. möglich, die Kennzeichnungsschaltung in mindestens einem definierten Bereich des Bauteils unmittelbar auf einer hierfür vorgesehenen Oberfläche oder in einer Ausnehmung anzuordnen. Die Kennzeichnungsschaltung kann hierzu bspw. direkt auf das Bauteil aufgedruckt werden. Dies kann derart erfolgen, dass das nichtleitende, halbleitende und leitende Material schichtweise an den vorgesehenen Stellen aufgebracht bzw. aufgedruckt wird und auf diese Weise die jeweiligen Schaltelemente Schicht für Schicht aufgebaut und miteinander leitend verbunden werden. Auf diese Weise ist es zudem möglich, mehrlagige Schaltungen aufzubauen, so dass auch komplexe Schaltungen realisierbar sind.

Je nach Material des zu kennzeichnenden Bauteils bzw. des jeweiligen Bereichs des Bauteils, an dem die Kennzeichnungsschaltung angeordnet werden soll, kann zwischen dem Bauteil und den Schaltelementen der Kennzeichnungsschaltung eine Isolierschicht vorgesehen sein. Die Isolierschicht kann bspw. vor dem Aufdrucken des eigentlichen Schaltelements ebenfalls aufgedruckt werden.

Des weiteren kann zum Schutz oder zur Abdeckung der Kennzeichnungsschaltung diese mit einer zusätzlichen Schicht überzogen werden, die ebenfalls im Druckverfahren aufgebracht werden kann und die Kennzeichnungsschaltung abdeckt. Ebenso ist es möglich die Kennzeichnungsschaltung im Inneren des Bauteils derart zu integrierten, dass diese von außen nicht sichtbar ist und von einer homogenen Oberfläche des Bauteils bedeckt ist. Auf diese Weise ist es möglich das jeweilige Bauteil mit Hilfe der Kennzeichnungsschaltung zu kennzeichnen, ohne dass dies von außen ersichtlich ist, da die Kennzeichnungsschaltung verdeckt in dem Bauteil integriert ist.

Entsprechend einer weiteren Ausführungsform kann die Kennzeichnungsschaltung eine Mehrzahl von definierten mathematischen Funktionen bereitstellen, wobei eine Auswahl einer jeweils zur Bestimmung des j-ten Ausgabeschlüssels bzw. des Sekundärschlüssels angewandten Funktion aus der Mehrzahl von Funktionen von dem (j-1)-ten Eingabeschlüssel bzw. dem (j=n)-ten Eingabeschlüssel abhängig ist.

Demnach können in der mindestens einen elektronischen Schaltung mehrere mathematische Funktionen hinterlegt sein. Wie voranstehend beschrieben, wird dies durch geeignete Anordnungen und Verbindungen der jeweiligen Schaltungselemente bzw. zusätzliche Schaltelemente erreicht.

Ist die Auswahl der zur Bestimmung des Ausgabeschlüssels vorgesehene Funktion von dem eingegebenen Eingabeschlüssel abhängig, so können als Kriterium der Auswahl bspw. ein definierter Aufbau bzw. ein definiertes Datenformat und/oder bestimmte Datenwerte des Eingabeschlüssels vorgesehen sein. Sind diese erfüllt, kommt die für diesen Eingabeschlüssel vorgesehene Funktion zur Anwendung.

Somit kann für einen bestimmten oder eine Anzahl von definierten Eingabeschlüsseln eine vorherbestimmte Funktion zur Erzeugung des Ausgabeschlüssels vorgesehen werden. Wird dagegen ein hiervon abweichender Eingabeschlüssel, im Folgenden als "falscher" Eingabeschlüssel bezeichnet, eingegeben, so kommen eine oder mehrere der anderen Funktionen zur Anwendung. Dies hat zur Folge, dass dementsprechend ein abweichender, "falscher" Ausgabeschlüssel erzeugt wird. Der falsche Ausgabeschlüssel kann anschließend in einem Vergleichsschritt identifiziert werden.

Es kann somit ausgeschlossen bzw. zumindest erschwert werden, dass die hinterlegten mathematischen Funktionen durch Testverfahren bestimmt und auf diese Weise die Kennungsschaltung nachgebaut werden kann. Nur bei Eingabe des korrekten Eingabeschlüssels wird gemäß dieser Ausführungsform die entsprechende Funktion verwendet, um den zugehörigen zweiten Ausgabeschlüssel zu erzeugen, der dann bei dem durchzuführenden Vergleichstest des zweiten Ausgabeschlüssels mit dem Kontrollschlüssel ein positives Ergebnis liefert.

Selbstverständlich kann eine Auswahl einer jeweiligen Funktion auch von anderen Ereignissen abhängig gemacht werden. So kann bspw. eine Zufallschaltung der Eingabe eines Eingabeschlüssels eine zufällig ausgewählte Funktion zuordnen und mittels derer den jeweiligen Ausgabeschlüssel bestimmen. Auch ist es möglich weitere Daten und Funktionen zu integrieren. Z. B. kann die Auswahl der jeweiligen mathematischen Funktion an eine Uhrzeit und/oder ein Datum der Schlüsseleingabe gekoppelt sein.

Somit kann bspw. das aktuelle Datum bzw. die aktuelle Uhrzeit in die mathematische Funktion integriert und zur Erzeugung eines datums- bzw. uhrzeitabhängigen Ausgabeschlüssels verwendet werden. Um sowohl zur Generierung des Ausgabeschlüssels als auch zur Kontrolle des von der Kennzeichnungsschaltung ausgegebenen Ausgabeschlüssels das identische Datum bzw. die identische Uhrzeit vorliegen zu haben, kann bspw. das aktuelle Datum bzw. die aktuelle Uhrzeit zusammen mit dem Primärschlüssel in die Kennzeichnungsschaltung eingegeben werden. Entsprechend wird der Kontrollschlüssel ebenfalls datums- bzw. uhrzeitabhängig bereitgestellt.

Außerdem können die mathematischen Funktionen vorgesehen sein, um in vorherbestimmter oder variabler Reihenfolge zur Erzeugung einer übergeordneten Gesamtfunktion miteinander kombiniert zu werden. Hierbei kann die Kopplung der Funktionen entsprechend der voranstehend beschriebenen Auswahl der Funktionen ebenfalls unter Berücksichtigung von anderen Ereignissen, bspw. unter Einbeziehung von Daten und Funktionen erfolgen.

Selbstverständlich kann ebenso lediglich eine einzelne definierte Funktion der Mehrzahl von Funktionen dauerhaft zur Bestimmung des Ausgabeschlüssels vorgesehen sein. Dies könnte bspw. sinnvoll sein, um auf einfache Weise einen Vergleich des Kontrollschlüssels mit dem ausgegebenen Ausgabeschlüssel zu ermöglichen und gleichzeitig die restlichen Funktionen der Mehrzahl von Funktionen als sogenannte "Dummy"-Funktionen ohne Verwendung vorzusehen. Somit kann die Komplexität der Schaltung erhöht werden, so dass eine Nachvollziehbarkeit im Rahmen einer Strukturanalyse und ggf. ein Nachbau verhindert bzw. erschwert wird. Generell müssen diese Schaltungen sehr aufwendig untersucht werden, um die tatsächlich verwendeten Funktionen zu identifizieren, wobei eine derartige Untersuchung bzw. Analyse in der Regel mit einer Zerstörung der zu untersuchenden Schaltung einhergeht.

Der Kontrolhschlüssel und/oder der Primärschlüssel wird von einer Datenbank bereitgestellt. Der Kontrollschlüssel kann also bereits als festgelegter Wert in der Datenbank hinterlegt sein. In diesem Fall wird in einem Vergleichsschritt der von der Kennzeichnungsschaltung ausgegebene Ausgabeschlüssel mit dem Kontrollschlüssel verglichen, der zuvor aus der Datenbank ausgelesen wird. Im Falle eines positiven Vergleichsergebnisses stimmen der Ausgabeschlüssel und der Kontrollschlüssel überein. Dies bedeutet, dass es sich bei der fraglichen Kennzeichnungsschaltung und damit auch mit dem damit gekennzeichneten Bauteil um eine originale Kennzeichnungsschaltung bzw. um ein originales Bauteil handelt. Unterscheidet sich im anderen Fall der Ausgabeschlüssel von dem Kontrollschlüssel, so liegt eine gefälschte Kennzeichnungsschaltung und somit ein gefälschtes Bauteil vor. Selbstverständlich kann der Kontrollschlüssel ebenso vor dem Auslesen aufgrund bestimmter Ereignisse erzeugt und bereitgestellt werden. Wie voranstehend bereits beschrieben, kann so bspw. eine Datums- bzw. Uhrzeitabhängigkeit ermöglicht werden.

Wenn der Primärschlüssel in der Datenbank hinterlegt ist, kann somit dem Primärschlüssel bereits ein zugehöriger Kontrollschlüssel abrufbar zugeordnet sein. Sowohl der Primärschlüssel als auch der Kontrollschlüssel können direkt zur Durchführung des beschriebenen Verfahrens zur Verifikation aus der Datenbank entnommen werden.

Entsprechend der Erfundung weist das Verfahren in Schritt a.) n Rekursionsschritte auf, wobei der j-te Rekursionsschritt mit j ∈ {1, 2, ..., n} die folgenden Schritte umfasst:
a1.) Auslesen eines von der Kennzeichnungsschaltung in Reaktion auf die Eingabe des (j-1)-ten Eingabeschlüssels ausgegebenen j-ten Ausgabeschlüssels,
a2.) Auslesen eines dem j-ten Ausgabeschlüssel zugeordneten j-ten Eingabeschlüssels aus einer Datenbank und
a3.) Eingabe des j-ten Eingabeschlüssels in die Kennzeichnungsschaltung,
wobei der Primärschlüssel als 0-ter Eingabeschlüssel eingegeben und der Sekundärschlüssel in Schritt b.) auf Basis des (j=n)-ten Eingabeschlüssels erstellt wird.

Es werden somit zusätzliche Rekursionsschritte bereitgestellt, wobei der Primärschlüssel zu Beginn als anfänglicher Eingabeschlüssel in die Kennzeichnungsschaltung eingegeben und am Ende des Verfahrens der Sekundärschlüssel ausgelesen wird. Zwischen diesen beiden Schritten a.) und b.) können die voranstehenden Schritte a1.) - a3.) der n Rekursionsschritte durchgeführt werden.

Es kann außerdem vorgesehen sein, dass ein Zugang zu der Datenbank zum Auslesen des jeweiligen j-ten Eingabeschlüssels ein Zugangskennwort erfordert.

Das Kennwort kann bspw. ein Benutzercode sein, der nur einem beschränkten Personenkreis bekannt ist. Mittels dieser Zugriffsbeschränkung kann die Sicherheit des beschriebenen Verfahrens zusätzlich erhöht werden. Ist das Kennwort nicht bekannt, so wird der Zugriff auf die Datenbank verweigert. Folglich kann der Schritt a2.) nicht ausgeführt und dementsprechend kein Eingabeschlüssel aus der Datenbank abgerufen werden.

Außerdem kann der Zugang zu der Datenbank zum Auslesen des j-ten Eingabeschlüssels den j-ten Ausgabeschlüssel erfordern.

Demnach wird für den Zugriff auf die Datenbank der korrekte Ausgabeschlüssel des jeweiligen Rekursionsschritts verwendet. Dieser kann bspw. in Kombination mit dem Kennwort oder allein anstelle des Kennworts für eine Zugriffsbeschränkung auf die Datenbank eingesetzt werden.

Auch kann es vorgesehen sein, dass zum Auslesen des j-ten Eingabeschlüssels der (j-1)-te Eingabeschlüssel eingesetzt wird.

Es wird für die Beschränkung des Zugriffs auf die Datenbank der vorherige Eingabeschlüssel verwendet. Ist dieser korrekt, so wird der Zugriff auf die Datenbank gewährt, andernfalls verweigert. Auch in diesem Fall kann eine gleichzeitige Verwendung in Kombination mit dem Kennwort und/oder dem Ausgabeschlüssel oder eine alleinige Verwendung des Eingabeschlüssels für die Zugriffsbeschränkung vorgesehen sein.

Gemäß einer anderen Ausführungsform umfasst der Schritt des Auslesens des j-ten Ausgabeschlüssels ein Auslesen einer j-ten Zufallszahl aus einer Zufallsschaltung der Kennzeichnungsschaltung, wobei der j-te Ausgabeschlüssel mit der j-ten Zufallszahl für eine Zuordnung zu dem j-ten Eingabeschlüssel angewendet werden kann.

Beispielsweise kann die Zufallsschaltung, die einen Zufallsgenerator bereitstellt, mindestens eine Zufallszahl generieren, die aus einer vorbestimmten Anzahl z von Zufallszahlen ausgewählt ist. In der Datenbank ist jeder der z Zufallszahlen aus der Anzahl z von Zufallszahlen ein entsprechender Eingabeschlüssel zugeordnet, so dass demnach in der Datenbank für diesen Schritt z Eingabeschlüssel hinterlegt sind. Entsprechend der ausgewählten Zufallszahl wird dann der der ausgewählten Zufallszahl zugeordnete Eingabeschlüssel ausgewählt.

Kann die Zufallsschaltung also bspw. eine Zufallszahl aus einer Anzahl von Zufallszahlen bestimmen, die ganzzahlig gewählt sind und zwischen 1 und 10 liegen, so können in der Datenbank zehn den Zufallszahlen zugeordnete Eingabeschlüssel für diesen Schritt bereitgestellt werden. Zum Abruf des Eingabeschlüssels aus der Datenbank kann die Zufallszahl an die Datenbank übermittelt werden. Wird das Verfahren mehrfach durchlaufen, kann die Sicherheit zusätzlich erhöht werden, da alle Zufallszahlen in der Kennzeichnungsschaltung hinterlegt und in der Datenbank derart dem jeweils zugehörigen Eingabeschlüssel zugeordnet sein müssen, dass zweifellos bei jedem Durchgang jeweils ein Eingabeschlüssel für das selbst Bauteil bzw. die selbe Kennzeichnungsschaltung bestimmt wird. Wird von einer fehlerhaften Kennzeichnungsschaltung eine falsche Zufallszahl bereitgestellt, wird dementsprechend ein falscher Eingabeschlüssel bestimmt, so dass die Kennzeichnungsschaltung als Fälschung identifiziert werden kann.

Auch gemäß der voranstehenden Ausführungsformen kann die Kennzeichnungsschaltung eine Mehrzahl von definierten mathematischen Funktionen bereitstellt, wobei eine Auswahl einer jeweils zur Bestimmung des j-ten Ausgabeschlüssels bzw. des Sekundärschlüssels angewandten Funktion aus der Mehrzahl von Funktionen von dem (j-1)-ten Eingabeschlüssel bzw. dem (j=n)-ten Eingabeschlüssel abhängig ist.

Entsprechend einer anderen Ausführungsform können die Schritte des Verfahrens mittels mindestens einer mobilen Recheneinheit mit Ein- und Ausgabevorrichtungen ausführbar sein. Eine derartige Recheneinheit kann bspw. in Form eines Handscanners oder eines mobilen Computers erfolgen, der über entsprechende Ein- und Ausgabevorrichtungen verfügt. Dies ermöglicht eine schnelle Überprüfung der Kennzeichnungsschaltung, so dass die Möglichkeit besteht, eine Überprüfung von Bauteilen bzw. Maschinen direkt vor Ort an ihrem Standort oder bspw. auf Messen durchzuführen und eine sofortige Aussage mittels des bereitgestellten Vergleichsergebnisses bereitstellen zu können.

Selbstverständlich können jedoch auch stationäre Recheneinheiten mit entsprechenden Ein- und Ausgabevorrichtungen, bspw. in Form von Scannern, zur Kontrolle der Bauteile bereitgestellt werden.

Es kann außerdem vorgesehen sein, dass die Datenbank in der Recheneinheit hinterlegt oder extern ausgeführt und kommunikationstechnisch mit der Recheneinheit gekoppelt ist. Somit kann ein lokaler Speicher in der mobilen oder lokalen Recheneinheit integriert oder mit dieser gekoppelt sein, in dem die Datenbank abgelegt ist. Bspw. kann somit mittels CDs, DVDs, Memory-Sticks, externen Festplatten oder ähnlicher Wechselmedien die Datenbank für die Recheneinheit verfügbar gemacht werden.

Ebenso ist es möglich, dass die Recheneinheit mittels eines Fernzugriffs über ein Netzwerk auf einen zentralen Server zugreifen kann, auf dem die Datenbank bereitgestellt ist. Gemäß dieser Ausführungsform kann dezentral und standortunabhängig mittels der Recheneinheit auf die Datenbank auf dem zentralen Server und die darin hinterlegten Schlüssel zugegriffen werden. Die Recheneinheit kann somit bspw. mittels LAN, WLAN oder geeigneter Kommunikationsstandards sowie Mobilfunkstandards auf die Datenbank zugreifen. Um die Datenbank vor nicht autorisiertem Zugriff und Auslesen der Schlüssel zu schützen, kann diese einen gesicherten Zugang umfassen. Dieser Zugang kann, wie voranstehend beschrieben, über Kennwort oder andere zugangsbeschränkende Kontrollmöglichkeiten erfolgen.

Des weiteren können die Eingabe- und die Ausleseschritte in bzw. aus der Kennzeichnungsschaltung mittels mindestens einer an der Kennzeichnungsschaltung vorgesehenen Ein- und Ausgabevorrichtung erfolgen.

Diese mindestens eine Ein- und Ausgabevorrichtung erlaubt somit einen Datenaustausch zwischen der Kennzeichnungsschaltung und der Recheneinheit. Bspw. kann hierzu an der Kennzeichnungsschaltung ein kombiniertes Ein- und Ausgabepad vorgesehen sein. Selbstverständlich ist es ebenso möglich mehrere Ein- und Ausgabepads sowie separate Ein-und separate Ausgabepads vorzusehen. Die Pads werden von einer entsprechend ausgeführten mobilen oder stationären Recheneinheit beaufschlagt, so dass eine kommunikationstechnische Verbindung für den Datenaustausch hergestellt wird. Die Pads können bspw. als flächige Elektroden oder schneckenförmige Spulen ausgebildet sein.

Gemäß einer weiteren Ausführungsform können die Eingabe- und die Ausleseschritte in bzw. aus der Kennzeichnungsschaltung ohne Berührung des zu kennzeichnenden Bauteils oder der Kennzeichnungsschaltung ausgeführt werden. Neben der voranstehend beschriebenen unmittelbaren Beaufschlagung eines oder mehrerer Ein- und Ausgabepads kann die Ein- und Ausgabevorrichtung der Kennzeichnungsschaltung demnach ebenso für eine kontaktlose Übertragung von Daten ausgeführt sein. So kann bspw. eine drahtlose Kommunikation in Form einer optischen oder elektromagnetischen Datenübertragung erfolgen.

Des weiteren kann die Kennzeichnungsschaltung mindestens eine Spannungsversorgung umfassen. Demnach umfasst die Kennzeichnungsschaltung eine eigene Spannungsversorgung, die bspw. in Form einer Batterie bereitgestellt werden kann. Selbstverständlich ist ebenso möglich, andere Spannungsversorgungen oder Anschlusskontakte für eine externe Spannungsversorgung vorzusehen, über die eine Spannung an die Kennzeichnungsschaltung angelegt bzw. eingekoppelt werden kann. Die Einkopplung der Spannung in die Kennzeichnungsschaltung kann über eine Anzahl von hierzu an der Kennzeichnungsschaltung vorgesehenen Spannungsversorgungspads erfolgen. Diese können bspw. als flächige Elektroden oder schneckenförmige Spulen ausgebildet sein. Ebenso ist eine Spannungseinkopplung auch über die voranstehend beschriebenen Ein- und Ausgabepads für den Datenaustausch sowie mittels mindestens einer induktiven Kopplung möglich.

Gemäß einer anderen Ausführungsform kann das Verfahren des weiteren ein Auslesen mindestens eines in der Kennzeichnungsschaltung integrierten Speichers umfassen. Wie bereits voranstehend beschrieben, kann die Kennzeichnungsschaltung mindestens einen integrierten Speicher umfassen, in dem Daten hinterlegt sind, die ausgelesen und bspw. für die Erstellung des Ausgabeschlüssels herangezogen werden können.

Des weiteren wird ein Verfahren zur Herstellung der voranstehend beschriebenen Kennzeichnungsschaltung zum Originalitätsschutz bereitgestellt, das nicht unter den Schutzberich des Anspruchs 1 fällt. Dieses umfasst mindestens einen der folgenden Schritte:
- Aufbringen von nicht-leitendem, halbleitendem und leitendem Material in jeweils dafür vorgesehene Bereiche auf einem Bauteil oder einem anderen Träger,
- Koppeln von halbleitenden und leitenden Bereichen, so dass mindestens eine mathematische Funktion entsteht,
- Koppeln von halbleitenden und leitenden Bereichen mit mindestens einem Ausgabepad,
- Koppeln von halbleitenden und leitenden Bereichen mit mindestens einem Spannungsversorgungspad.

Außerdem wird ein Bauteil mit integrierter Kennzeichnungsschaltung bereitgestellt, das nicht unter den Schutzberich des Anspruchs 1 fällt wobei die integrierte Kennzeichnungsschaltung zur Eingabe eines Eingabeschlüssels in die Kennzeichnungsschaltung und zum Auslesen eines von der Kennzeichnungsschaltung in Reaktion auf die Eingabe ausgegebenen Ausgabeschlüssels ausgebildet ist und die Kennzeichnungsschaltung außerdem nicht leitende, halbleitende und leitende Materialien umfasst, die derart angeordnet und miteinander verbunden sind, dass mindestens eine elektronische Schaltungsanordnung gebildet wird, die mindestens eine definierte mathematische Funktion umfasst und derart konfiguriert ist, aus dem in die Kennzeichnungsschaltung eingegebenen Eingabeschlüssel den Ausgabeschlüssel mindestens mittels der mindestens einen mathematischen Funktion zu bestimmen und zum Auslesen bereitzustellen.

Des weiteren wird eine Recheneinheit bereitgestellt, die nicht unter den Schutzberich des Anspruchs 1 fällt, und die dazu konfiguriert ist, das voranstehend beschriebene Verfahren auszuführen. Die Recheneinheit kann als mobile oder stationäre Recheneinheit ausgeführt sein.

Weitere Vorteile und Ausgestaltungen der Erfindung ergeben sich aus der Beschreibung und der beiliegenden Zeichnung.

### Kurzbeschreibung der Zeichnungen

Figur 1 zeigt eine auf einem Bauteil aufgebrachte Kennzeichnungsschaltung in schematischer Draufsicht.

Figur 2 zeigt die auf dem Bauteil angeordnete Kennzeichnungsschaltung in einer schematischen Seitenansicht.

Figur 3 zeigt ein weiteres Beispiel einer Kennzeichnungsschaltung in einer schematischen Draufsicht.

Figur 4 zeigt ein weiteres Beispiel einer Kennzeichnungsschaltung in schematischer Draufsicht.

Figur 5 zeigt ein weiteres Biespiel einer Kennzeichnungsschaltung in einem seitlichen Querschnitt.

Figur 6 zeigt ein weiteres Biespiel einer auf einem Bauteil aufgebrachten Kennzeichnungsschaltung in schematischer Draufsicht.

Figur 7a zeigt ein weiteres Biespiel einer Kennzeichnungsschaltung nach einem ersten Herstellungsschritt in schematischer Seitenansicht.

Figur 7b zeigt die Kennzeichnungsschaltung nach einem zweiten Herstellungsschritt in schematischer Seitenansicht.

Figur 8 zeigt ein Ablaufschema eines Verfahrens zur Verifikation einer in einem Bauteil integrierten Kennzeichnungsschaltung, das nicht unter den Schutzberich des Anspruchs 1 fällt.

Figur 9 zeigt ein Ablaufschema einer Ausführungsform eines Verfahrens zur Verifikation einer in einem Bauteil integrierten Kennzeichnungsschaltung gemäß der Erfindung.

Figur 10 zeigt ein Ablaufschema einer weiteren Ausführungsform eines Verfahrens zur Verifikation einer in einem Bauteil integrierten Kennzeichnungsschaltung.

### Ausführliche Beschreibung

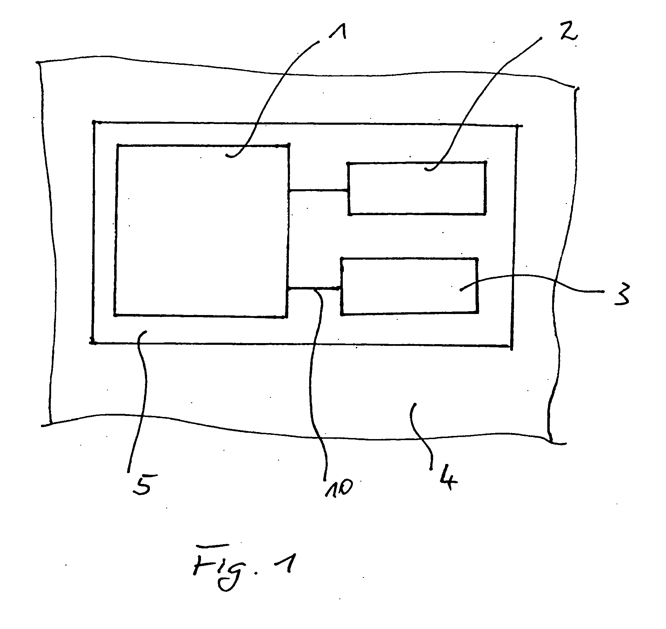

Figur 1 zeigt eine schematische Darstellung einer auf einem Bauteil 4 aufgebrachten Kennzeichnungsschaltung 5 mit einem eine elektronische Schaltung repräsentierenden Schaltkreis 1, einem kombinierten Ein- und Ausgabepad 3 und mindestens einem Spannungsversorgungspad 2, die jeweils in der Kennzeichnungsschaltung 5 integriert und mit dem Schaltkreis 1 verbunden sind.

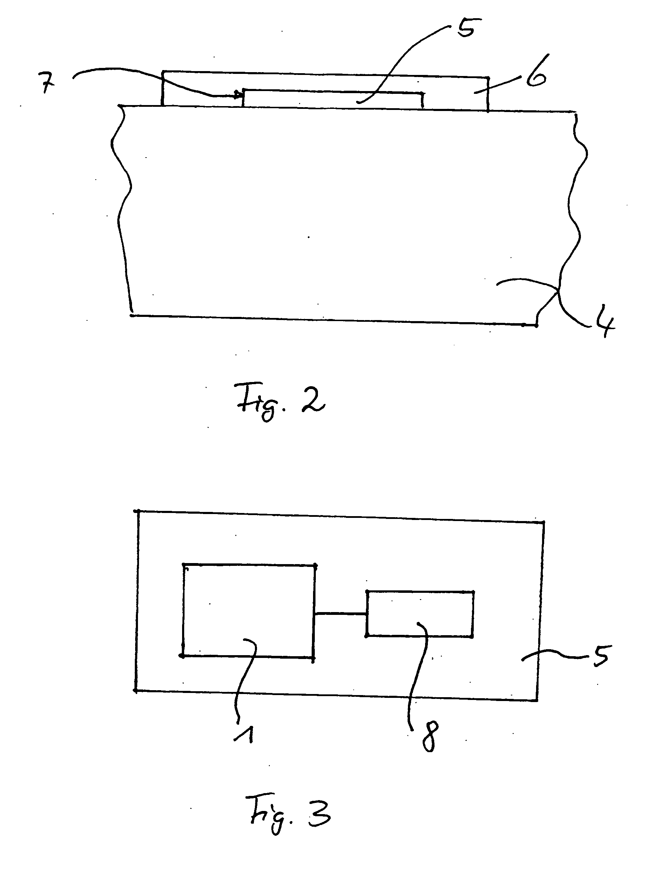

Figur 2 zeigt eine schematische Darstellung der auf dem Bauteil 4 angeordneten Kennzeichnungsschaltung 5, wobei äußere freie Oberflächen der Kennzeichnungsschaltung 5 mittels einer zusätzlichen Abdeckschicht bzw. Abdeckung 6 abgedeckt und versiegelt sind, so dass sie nach außen weder sichtbar noch leicht zugänglich sind.

Figur 3 zeigt eine schematische Draufsicht einer Kennzeichnungsschaltung 5 mit einem kombinierten Spannungsversorgungs- und Ein- und Ausgabepad 8, das kommunikationstechnisch mit einem Schaltkreis 1 verbunden ist.

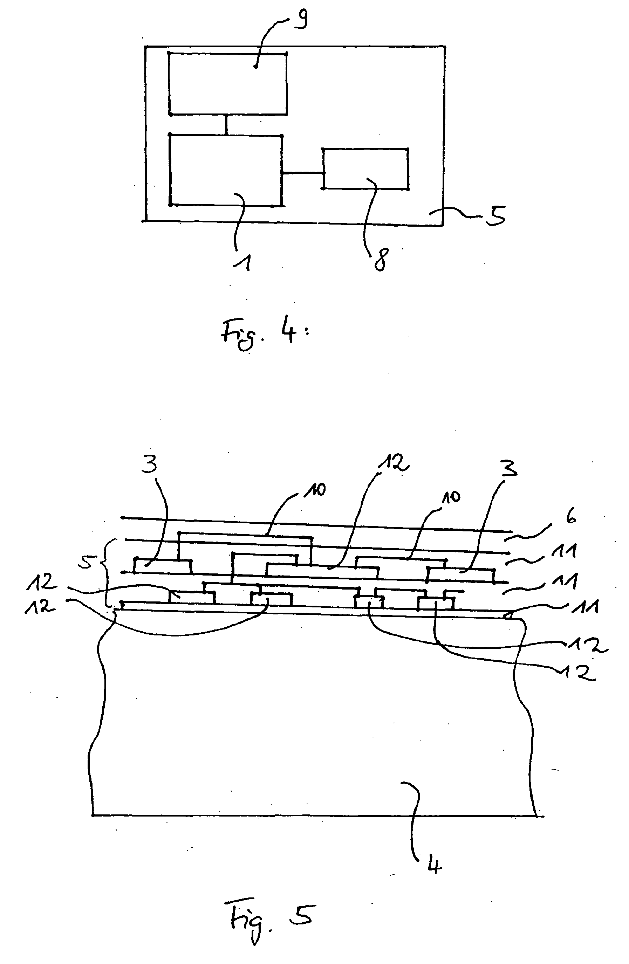

Figur 4 zeigt eine schematische Draufsicht einer Kennzeichnungsschaltung 5 mit einem Schaltkreis 1, einem kombinierten Spannungsversorgungs- und Ein- und Ausgabepad 8 sowie einem mit dem Schaltkreis 1 verbundenen zusätzlichen Speicher 9.

Figur 5 zeigt einen seitlichen Querschnitt einer auf einem Bauteil 4 angeordneten Kennzeichnungsschaltung 5, die aus mehreren Isolierschichten 11 aus nicht leitendem Material besteht sowie aktive Elemente 12 aus leitendem oder halbleitendem Material umfasst, die über leitende Abschnitte 10 kommunikationstechnisch miteinander verbunden sind. Des weiteren umfasst die Kennzeichnungsschaltung Ein- und Ausgabepads 3 und ist durch die Abdeckung 6 an ihren äußeren Oberflächen abgedeckt bzw. versiegelt, die nicht in Kontakt mit dem Bauteil 4 stehen.

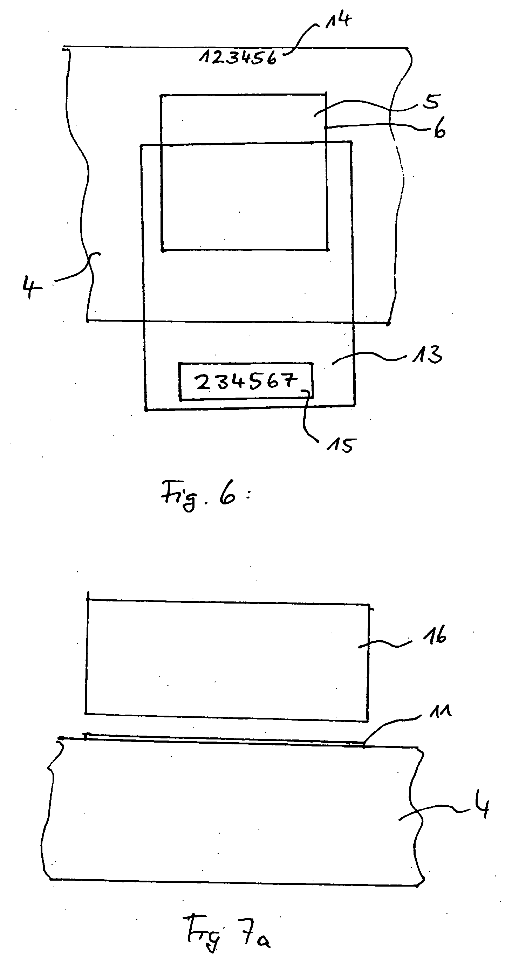

Figur 6 zeigt eine schematische Draufsicht einer auf einem Bauteil 4 angeordneten Kennzeichnungsschaltung 5, die eine Abdeckung 6 aufweist. In die Kennzeichnungsschaltung 5 wird ein Eingabeschlüssel 14 eingegeben. Anschließend kann ein Ausgabeschlüssel 15 mittels eines Ein- und Ausgabegeräts 13 ausgelesen werden. Dieses kann, wie voranstehend beschreiben, als mobile oder stationäre Recheneinheit ausgeführt sein und Ein- und Ausgabevorrichtungen umfassen. Der Eingabeschlüssel 14 kann am Bauteil 4 selbst angebracht sein, vom Hersteller angefordert werden oder auf andere bekannte Weise tabelliert sein bzw. von einer Datenbank bereitgestellt werden.

Figur 7a zeigt eine auf einem Bauteil 4 angeordnete Isolierschicht 11, die von einem Druckkopf 16 auf das Bauteil 4 aufgedruckt wird. Dieses Aufdrucken der Isolierschicht 11 stellt einen ersten Verfahrensschritt zum Aufbringen der Kennzeichnungsschaltung auf das Bauteil 4 dar.

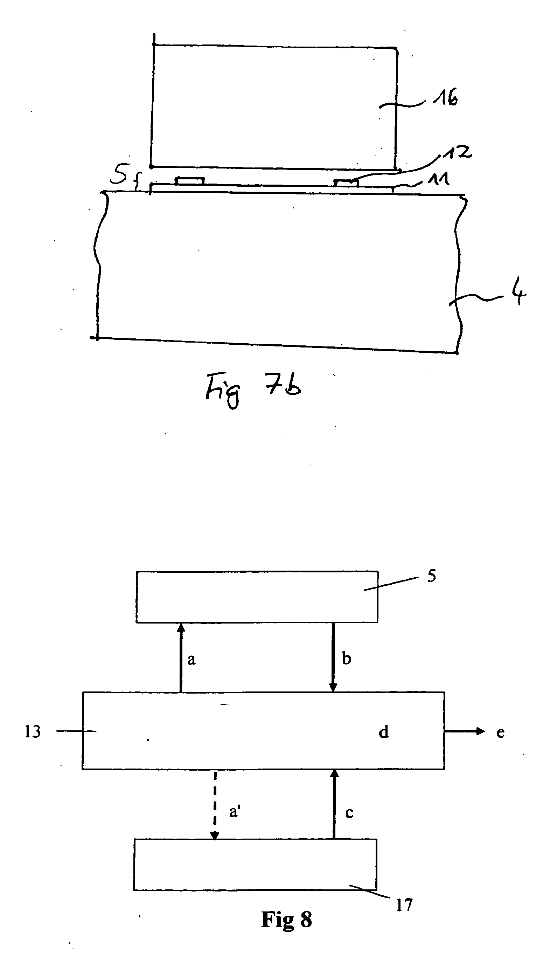

Figur 7b zeigt die auf dem Bauteil 4 aufgebrachte Kennzeichnungsschaltung 5 nach einem weiteren Verfahrensschritt, bei dem die aktiven Elemente 12 mittels des Druckkopfs 16 auf die Isolierschicht 11 aufgedruckt werden. Die aktiven Elemente 12 können aus einem halbleitenden oder leitenden Material bspw. einem halbleitenden oder leitenden Kunststoff oder Metall bestehen.

Figur 8 zeigt ein Ablaufschema eines Verfahrens zur Verifikation einer in einem Bauteil integrierten Kennzeichnungsschaltung, das nicht unter den Schutzberich des Anspruchs 1 fällt. Demnach umfasst die dargestellte Ausführungsform die folgenden Schritte:
a.) Eingabe eines Primärschlüssels in die Kennzeichnungsschaltung 5,
b.) Auslesen eines von der Kennzeichnungsschaltung 5 in Reaktion auf die Eingabe des Primärschlüssels ausgegebenen Sekundärschlüssels.
c.) Bereitstellen eines dem Primärschlüssel zugeordneten Kontrollschlüssels,
d.) Vergleichen des Kontrollschlüssels mit dem ausgegebenen Sekundärschlüssel und
e.) Bereitstellen eines Ergebnisses des Vergleichsschritts.

Im Falle einer Übereinstimmung des Sekundärschlüssels mit dem Kontrollschlüssel wird das mit der Kennzeichnungsschaltung gekennzeichnete Bauteil als originales Bauteil und im gegenteiligen Falle als gefälschtes Bauteil identifiziert. In der Kennzeichnungsschaltung 5 ist hierzu eine definierte mathematische Funktion integriert und die Kennzeichnungsschaltung derart konfiguriert, aus dem in die Kennzeichnungsschaltung 5 eingegebenen Primärschlüssel den Sekundärschlüssel mindestens unter Anwendung der mathematischen Funktion zu bestimmen und zum Auslesen bereitzustellen. Der in dem Schritt a.) eingegebene Primärschlüssel wird im dargestellten Verfahren von der mobilen Recheneinheit 13 in die Kennzeichnungsschaltung 5 eingegeben. Der Primärschlüssel ist hierzu in der mobilen Recheneinheit hinterlegt. Selbstverständlich ist es ebenso möglich, den Primärschlüssel in einem externen Speicher bzw. einer externen Datenbank zu hinterlegen (nicht dargestellt), der bzw. die kommunikationstechnisch mit der mobilen Recheneinheit 13 gekoppelt ist, so dass die mobile Recheneinheit 13 Zugriff auf die darin hinterlegten Daten hat. Der Kontrollschlüssel ist in der dargestellten Ausführungsform in der Datenbank 17 hinterlegt, wobei der Kennzeichnungsschlüssel dem verwendeten Primärschlüssel zugeordnet ist. In einem optionalen Schritt a'.) kann der Primärschlüssel zur Bestimmung und zum anschließenden Auslesen des zugehörigen Kontrollschlüssels an die Datenbank geleitet werden.

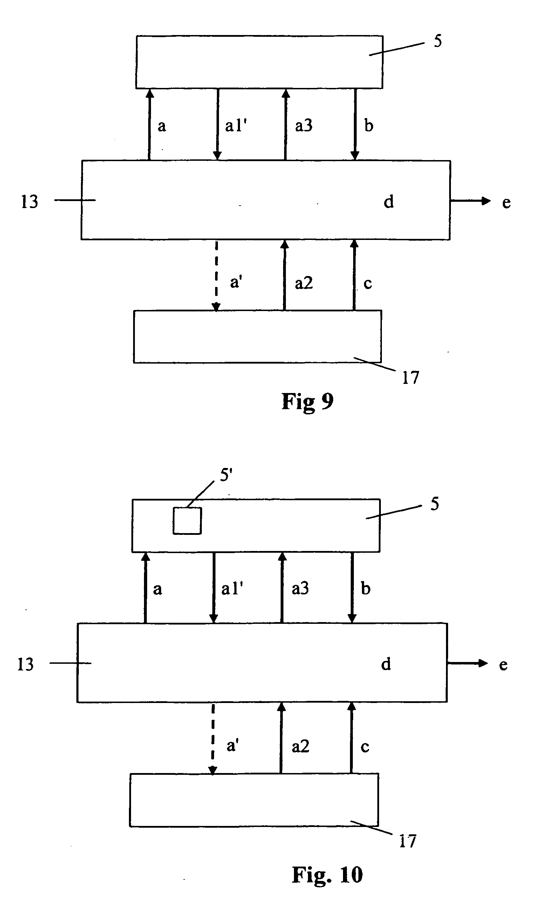

Figur 9 zeigt ein Ablaufschema einer Ausführungsform eines Verfahrens zur Verifikation einer in einem Bauteil integrierten Kennzeichnungsschaltung 5 gemäß der Erfindung. Demnach kann das Verfahren aus Figur 8 in Schritt a.) n Rekursionsschritte aufweisen, wobei nachfolgend eine Ausführungsform für den Fall n=1 dargestellt ist. Demnach umfasst das Verfahren die folgenden Schritte:
a.) Eingabe des Primärschlüssels in die Kennzeichnungsschaltung 5 mittels der mobilen Recheneinheit 13.
a1.) Auslesen eines von der Kennzeichnungsschaltung 5 in Reaktion auf die Eingabe des Primärschlüssels ausgegebenen Ausgabeschlüssels in die mobile Recheneinheit 13,
a2.) Auslesen eines dem Ausgabeschlüssel zugeordneten Eingabeschlüssels aus der Datenbank 17, wobei in diesem Schritt ein Weiterleiten a'.) des Ausgabeschlüssels von der mobilen Recheneinheit 13 in die Datenbank 17 umfasst sein kann, um aus der Datenbank 17 den dem Ausgabeschlüssel zugeordneten Eingabeschlüssel zu bestimmen.
a3.) Eingabe des Eingabeschlüssels in die Kennzeichnungsschaltung 5 mittels der mobilen Recheneinheit 13.
Anschließend folgen die bereits beschriebenen folgenden Schritte:
b.) Auslesen eines von der Kennzeichnungsschaltung 5 in Reaktion auf die Eingabe des Eingabeschlüssels eingegebenen Sekundärschlüssels,
c.) Bereitstellen eines dem Primärschlüssel zugeordneten Kontrollschlüssels aus der Datenbank 17 in die mobile Recheneinheit 13,
d.) Vergleichen des Kontrollschlüssels mit dem ausgegebenen Sekundärschlüssel in der mobilen Recheneinheit und
e.) Bereitstellen eines Ergebnisses des Vergleichsschritts mittels der mobilen Recheneinheit 13.

Wird der beschriebene Rekursionsschritt mit den Schritten a1.) bis a3.) n-mal wiederholt, so wird in einem j-ten Rekursionsschritt mit j ∈ {1, 2, ... n}, der von der Kennzeichnungsschaltung ausgegebene j-te Ausgabeschlüssel in Reaktion auf die Eingabe des (j-1)-ten Eingabeschlüssels ausgelesen. Anschließend wird aus der Datenbank 17 ein dem j-ten Ausgabeschlüssel zugeordneter j-ter Eingabeschlüssel ausgelesen und der j-te Eingabeschlüssel in die Kennzeichnungsschaltung 5 eingegeben. Hierbei wird der Primärschlüssel als 0-ter Eingabeschlüssel eingegeben und der Sekundärschlüssel in Schritt b.) auf Basis des (j=n)-ten Eingabeschlüssels erstellt.

Figur 10 zeigt ein Ablaufschema einer weiteren Ausführungsform eines Verfahrens zur Verifikation einer in einem Bauteil integrierten Kennzeichnungsschaltung. Die beschriebene Ausführungsform basiert auf der Ausführungsform gemäß Figur 9, wobei der Schritt a1.) des Auslesens des Ausgabeschlüssels des weiteren ein Auslesen einer Zufallszahl aus einer als Zufallsgenerator ausgebildeten Zufallsschaltung 5' der Kennzeichnungsschaltung 5 umfasst und der Ausgabeschlüssel mit der Zufallszahl für eine Zuordnung des nächsten Eingabeschlüssels angewendet wird, der in Schritt a2.) aus der Datenbank ausgelesen wird. Hierzu wird die Zufallszahl in dem Schritt a1'.) zusammen mit dem Ausgabeschlüssel von der mobilen Recheneinheit 13 ausgelesen und in einem Schritt a'.) in die Datenbank 17 zur zufallszahlabhängigen Bestimmung des Eingabeschlüssels eingegeben. Anschließend erfolgen die bereits in Figur 9 beschriebenen Schritte a2.), a3.), b.), c.), d.) und e.).

In den voranstehend beschriebenen Ausführungsformen kann es ebenso vorgesehen sein, dass der Schritt d.) des Vergleichens des Kontrollschlüssels mit dem Sekundärschlüssel innerhalb der Kennzeichnungsschaltung erfolgt. Hierzu kann der Kontrollschlüssel in der Kennzeichnungsschaltung bereits hinterlegt oder bspw. über die mobile Recheneinheit in die Kontrollschaltung eingegeben werden. In diesem Fall ist die Kontrollschaltung derart konfiguriert, den beschriebenen Vergleichsschritt auszuführen und ein Ergebnis des Vergleichsschritts bereitzustellen. Somit trifft bereits die Kennzeichnungsschaltung die Entscheidung, ob es sich bei der Kennzeichnungsschaltung bzw. dem zugehörigen Bauteil um ein Originalbauteil oder eine Fälschung handelt.

## Patentansprüche

1. Verfahren zur Verifikation einer in einem zu kennzeichnenden Bauteil (4) integrierten Kennzeichnungsschaltung (5), mit den folgenden Schritten:
a.) Eingabe eines Primärschlüssels (14) in die Kennzeichnungsschaltung (5),
b.) Auslesen eines von der Kennzeichnungsschaltung (5) in Reaktion auf die Eingabe des Primärschlüssels ausgegebenen Sekundärschlüssels (15),
c.) Bereitstellen eines dem Primärschlüssel (14) zugeordneten Kontrollschlüssels,
d.) Vergleichen des Kontrollschlüssels mit dem ausgegebenen Sekundärschlüssel (15),
e.) Bereitstellen eines Ergebnisses des Vergleichsschritts,
wobei im Falle einer Übereinstimmung des Sekundärschlüssels mit dem Kontrollschlüssel das mit der Kennzeichnungsschaltung gekennzeichnete Bauteil als originales Bauteil und im gegenteiligen Falle als gefälschtes Bauteil identifiziert wird, und wobei die Kennzeichnungsschaltung (5) nicht leitende (11), halbleitende (12) und leitende Materialien (10) umfasst, die derart angeordnet und miteinander verbunden sind, dass mindestens eine elektronische Schaltungsanordnung (1) gebildet wird, die mindestens eine definierte mathematische Funktion umfasst und derart konfiguriert ist, aus dem in die Kennzeichnungsschaltung (5) eingegebenen Primärschlüssel (14) den Sekundärschlüssel (15) mindestens unter Anwendung der mindestens einen mathematischen Funktion zu bestimmen und zum Auslesen bereitzustellen, **dadurch gekennzeichnet, dass** der Kontrollschlüssel und/oder der Primärschlüssel (14) von einer Datenbank bereitgestellt wird, und dass das Verfahren in Schritt a.) n Rekursionsschritte aufweiset, wobei der j-te Rekursionsschritt mit j ∈ {1, 2, ..., n} die folgenden Schritte umfasst:
a1.) Auslesen eines von der Kennzeichnungsschaltung in Reaktion auf die Eingabe eines (j-1)-ten Eingabeschlüssels ausgegebenen j-ten Ausgabeschlüssels,
a2.) Auslesen eines dem j-ten Ausgabeschlüssel zugeordneten j-ten Eingabeschlüssels aus einer Datenbank und
a3.) Eingabe des j-ten Eingabeschlüssels in die Kennzeichnungsschaltung,
wobei der Primärschlüssel als 0-ter Eingabeschlüssel eingegeben und der Sekundärschlüssel in Schritt b.) auf Basis des (j=n)-ten Eingabeschlüssels erstellt wird.

2. Verfahren nach Anspruch 1, wobei ein Zugang zu der Datenbank zum Auslesen des jeweiligen j-ten Eingabeschlüssels ein Zugangskennwort erfordert.

3. Verfahren nach Anspruch 1 oder 2, wobei der Zugang zu der Datenbank zum Auslesen des j-ten Eingabeschlüssels den j-ten Ausgabeschlüssel erfordert.

4. Verfahren nach Anspruch 1 bis 3, wobei zum Auslesen des j-ten Eingabeschlüssels der (j-1)-te Eingabeschlüssel eingesetzt wird.

5. Verfahren nach einem der Ansprüche 1 bis 4, wobei der Schritt a1.) des Auslesens des j-ten Ausgabeschlüssels ein Auslesen einer j-ten Zufallszahl aus einem Zufallsgenerator der Kennzeichnungsschaltung umfasst und der j-te Ausgabeschlüssel mit der j-ten Zufallszahl für eine Zuordnung zu dem j-ten Eingabeschlüssel angewendet wird.

6. Verfahren nach einem der Ansprüche 1 bis 5, wobei die Kennzeichnungsschaltung (5) eine Mehrzahl von definierten mathematischen Funktionen bereitstellt, wobei eine Auswahl einer jeweils zur Bestimmung des j-ten Ausgabeschlüssels bzw. des Sekundärschlüssels angewandten Funktion aus der Mehrzahl von Funktionen von dem (j-1)-ten Eingabeschlüssel bzw. dem (j=n)-ten Eingabeschlüssel abhängig ist.

7. Verfahren nach einem der Ansprüche 1 bis 6, wobei die Schritte des Verfahrens mittels mindestens einer mobilen Recheneinheit (13) mit Ein- und Ausgabevorrichtungen ausführbar sind.

8. Verfahren nach Anspruch 7, wobei die Datenbank in der mobilen Recheneinheit (13) hinterlegt, oder extern ausgeführt und kommunikationstechnisch mit der mobilen Recheneinheit (13) gekoppelt ist.

9. Verfahren nach einem der Ansprüche 1 bis 8, wobei die Eingabe- und die Ausleseschritte in bzw. aus der Kennzeichnungsschaltung mittels mindestens einer an der Kennzeichnungsschaltung (5) vorgesehenen Ein- und Ausgabevorrichtung erfolgen.

10. Verfahren nach einem der Ansprüche 1 bis 9, wobei die Kennzeichnungsschaltung (5) verdeckt in dem Bauteil (4) integriert ist.

11. Verfahren nach einem der Ansprüche 1 bis 10, wobei die Eingabe- und die Ausleseschritte in bzw. aus der Kennzeichnungsschaltung ohne Berührung des zu kennzeichnenden Bauteils (4) oder der Kennzeichnungsschaltung (5) ausgeführt werden.

12. Verfahren nach einem der Ansprüche 1 bis 11, wobei die Kennzeichnungsschaltung (5) mindestens eine Spannungsversorgung umfasst.

13. Verfahren nach einem der Ansprüche 1 bis 12, wobei das Verfahren des Weiteren ein Auslesen mindestens eines in der Kennzeichnungsschaltung (5) integrierten Speichers (9) umfasst.

## Claims

1. Method of verifying an identification circuit (5) integrated in a component (4) to be identified, comprising the following steps:
a.) inputting a primary key (14) into the identification circuit (5),
b.) reading a secondary key (15) which is output by the identification circuit (5) in reaction to the input of the primary key,
c.) providing a control key assigned to the primary key (14),
d.) comparing the control key with the output secondary key (15),
e.) providing a result of the comparison step,
wherein in case of a match of the secondary key to the control key the component identified with the identification circuit is identified as an original component, and in the opposite case as a counterfeit component, and wherein the identification circuit (5) comprises non-conducting (11), semiconducting (12) and conducting materials (10) which are disposed and connected to each other such that at least one electronic circuit arrangement (1) is formed which comprises at least one defined mathematical function and is configured so as to determine the secondary key (15) from the primary key (14) input into the identification circuit (5), at least using the at least one mathematical function, and to provide said secondary key for readout, **characterised in that** the control key and/or the primary key (14) is provided by a database, and **in that** the method comprises n recursion steps in step a.), wherein the j^{th} recursion step, where j ∈ {1, 2, ..., n}, comprises the following steps:
a1.) reading a j^{th} output key which is output by the identification circuit in reaction to the input of a (j-1)^{th} input key,
a2.) reading from a database a j^{th} input key assigned to the j^{th} output key, and
a3.) inputting the j^{th} input key into the identification circuit,
wherein the primary key is input as the 0^{th} input key and the secondary key is created in step b.) on the basis of the (j=n)^{th} input key.

2. Method according to claim 1, wherein access to the database to read the respective j^{th} input key requires an access password.

3. Method according to claim 1 or 2, wherein access to the database to read the j^{th} input key requires the j^{th} output key.

4. Method according to claims 1 to 3, wherein the (j-1)^{th} input key is used to read the j^{th} input key.

5. Method according to any one of claims 1 to 4, wherein step a1.) of reading the j^{th} output key comprises reading a j^{th} random number from a random generator of the identification circuit, and the j^{th} output key is used with the j^{th} random number for an assignment to the j^{th} input key.

6. Method according to any one of claims 1 to 5, wherein the identification circuit (5) provides a plurality of defined mathematical functions, wherein a choosing of a function used respectively to determine the j^{th} output key and the secondary key from the plurality of functions depends respectively on the (j-1)^{th} input key and on the (j=n)^{th} input key.

7. Method according to any one of claims 1 to 6, wherein the steps of the method can be carried out by means of at least one mobile processing unit (13) having input and output devices.

8. Method according to claim 7, wherein the database is stored in the mobile processing unit (13) or is implemented externally and is coupled to the mobile processing unit (13) by communication technology.

9. Method according to any one of claims 1 to 8, wherein the input and reading steps into and from the identification circuit take place by means of at least one input and output device provided on the identification circuit (5).

10. Method according to any one of claims 1 to 9, wherein the identification circuit (5) is integrated in the component (4) in a hidden manner.

11. Method according to any one of claims 1 to 10, wherein the input and reading steps into and from the identification circuit are carried out without touching the component (4) to be identified or the identification circuit (5).

12. Method according to any one of claims 1 to 11, wherein the identification circuit (5) comprises at least one voltage supply.

13. Method according to any one of claims 1 to 12, wherein the method further comprises a reading of at least one memory (9) integrated in the identification circuit (5).

## Revendications

1. Procédé de vérification d'un circuit d'identification (5) intégré dans un composant (4) à identifier, comportant les étapes consistant à :
a.) entrer une clé primaire (14) dans le circuit d'identification (5) ;
b.) extraire une clé secondaire (15) délivrée par le circuit d'identification (5) en réponse à l'entrée de la clé primaire ;
c.) mettre à disposition une clé de contrôle associée à la clé primaire (14) ;
d.) comparer la clé de contrôle à la clé secondaire (15) délivrée ;
e.) mettre à disposition un résultat d'étape de comparaison,
sachant que dans le cas d'une concordance de la clé secondaire avec la clé de contrôle, le composant identifié avec le circuit d'identification est identifié comme composant d'origine ou dans le cas contraire comme un composant contrefait, et sachant que le circuit d'identification (5) comporte des matériaux non conducteurs (11), semi-conducteurs (12) et conducteurs (10), lesquels sont disposés et reliés entre eux de telle manière qu'au moins un ensemble de circuit (1) électronique est créé, lequel comporte au moins une fonction mathématique définie et qui est configuré de manière à déterminer à partir de la clé primaire (14) entrée dans le circuit d'identification (5), la clé secondaire (15) au moins en appliquant la fonction mathématique au moins au nombre de une et de manière à effectuer les extractions, **caractérisé en ce que** la clé de contrôle et/ou la clé primaire (14) sont fournies par une banque de données, et **en ce que** le procédé présente à l'étape a.) n étapes de récursion, sachant la j-ième étape de récursion avec j ∈ {1, 2, ..., n} comporte les étapes suivantes consistant à :
a1.) extraire une j-ième clé de sortie délivrée par le circuit d'identification en réponse à l'entrée d'une (j-1)-ième clé d'entrée ;
a2.) extraire une j-ième clé d'entrée de la banque de données, associée à la j-ième clé de sortie ; et
a3.) entrer la j-ième clé d'entrée dans le circuit d'identification,
sachant que la clé primaire est entrée comme clé d'entrée 0-ter et que la clé secondaire est émise lors de l'étape b.) sur la base de la (j=n)-ième clé d'entrée.

2. rocédé selon la revendication 1, sachant qu'un accès à la banque de données aux fins d'extraire la j-ième clé d'entrée respective requiert un mot de passe d'accès.

3. rocédé selon la revendication 1 ou 2, sachant que l'accès à la banque de données aux fins d'extraire la j-ième clé d'entrée, requiert la j-ième clé de sortie.

4. rocédé selon la revendication 1 à 3, sachant qu'on utilise la (j-1)-ième clé d'entrée pour extraire la j-ième clé d'entrée.

5. Procédé selon l'une quelconque des revendications 1 à 4, sachant que l'étape a1.) consistant à extraire la j-ième clé de sortie comporte une extraction d'un j-ième nombre aléatoire d'un générateur de nombres aléatoires du circuit d'identification et que la j-ième clé de sortie est appliquée avec le j-ième nombre aléatoire pour une association à la j-ième clé d'entrée.

6. Procédé selon l'une quelconque des revendications 1 à 5, sachant que le circuit d'identification (5) fournit une pluralité de fonctions mathématiques définies, sachant qu'une extraction d'une fonction issue de la pluralité de fonctions, appliquée respectivement pour déterminer la j-ième clé de sortie ou la clé secondaire dépend de la (j-1)-ième clé d'entrée ou de la (j=n)-ième clé d'entrée.

7. Procédé selon l'une quelconque des revendications 1 à 6, sachant que les étapes du procédé peuvent être exécutées au moyen au moins d'une unité de calcul (13) mobile dotée de dispositifs d'entrée et de sortie.

8. Procédé selon la revendication 7, sachant que la banque de données est enregistrée dans l'unité de calcul (13) mobile, ou est exécutée de manière externe et est couplée selon la technique de communication à l'unité de calcul (13) mobile.

9. Procédé selon l'une quelconque des revendications 1 à 8, sachant que les étapes d'entrée et d'extraction sont effectuées dans ou depuis le circuit d'identification au moyen au moins d'un dispositif d'entrée et de sortie prévu sur le circuit d'identification (5).

10. Procédé selon l'une quelconque des revendications 1 à 9, sachant que le circuit d'identification (5) est intégré de manière cachée dans le composant (4).

11. Procédé selon l'une quelconque des revendications 1 à 10, sachant que les étapes d'entrée et d'extraction sont exécutées dans ou depuis le circuit d'identification (5) sans toucher le composant (4) à identifier.

12. Procédé selon l'une quelconque des revendications 1 à 11, sachant que le circuit d'identification (5) comporte au moins un dispositif d'alimentation en tension.

13. Procédé selon l'une quelconque des revendications 1 à 12, sachant que le procédé comporte en outre une étape d'extraction d'au moins une unité de stockage (9) intégrée dans le circuit d'identification (5).
